(19) Europäisches Patentamt / European Patent Office / Office européen des brevets

(11) **EP 2 553 479 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**21.07.2021 Patentblatt 2021/29**

(45) Hinweis auf die Patenterteilung:
**29.08.2018 Patentblatt 2018/35**

(21) Anmeldenummer: **11709397.1**

(22) Anmeldetag: **21.03.2011**

(51) Int Cl.:
*G01R 31/58* (2020.01)    *G08B 29/06* (2006.01)
*G08B 29/12* (2006.01)

(86) Internationale Anmeldenummer:
**PCT/EP2011/054189**

(87) Internationale Veröffentlichungsnummer:
**WO 2011/117168 (29.09.2011 Gazette 2011/39)**

(54) **VERFAHREN ZUM ÜBERWACHEN VON LEITUNGEN DURCH BESTIMMUNG DES ELEKTRISCHEN WIDERSTANDS**

METHOD FOR MONITORING LINES BY DETERMINING THE ELECTRICAL RESISTANCE

PROCÉDÉ POUR SURVEILLER DES LIGNES ÉLECTRIQUES PAR DÉTERMINATION DE LA RÉSISTANCE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.03.2010 DE 102010003353**

(43) Veröffentlichungstag der Anmeldung:
**06.02.2013 Patentblatt 2013/06**

(73) Patentinhaber: **Robert Bosch GmbH**
**70442 Stuttgart (DE)**

(72) Erfinder:
• **GUERTNER, Michael**
**85635 Hoehenkirchen-Siegertsbrunn (DE)**
• **PREISINGER, Marcus**
**86152 Augsburg (DE)**

(56) Entgegenhaltungen:
EP-A1- 1 855 261          EP-A1- 2 093 737
DE-A1-102005 060 123      DE-A1-102008 003 799
DE-A1-102008 015 999

EP 2 553 479 B2

**Beschreibung**

Die Erfindung betrifft ein Verfahren zum Überwachen von Leitungen und eine Überwachungseinrichtung zur Durchführung des Verfahrens.

Stand der Technik

Es wird ein System betrachtet, in dem mindestens ein elektrischer Verbraucher über Leitungen, wie bspw. über Energieversorgungs- und Kommunikationsleitungen, an eine Zentrale angeschlossen ist. Dabei kann der mindestens eine Verbraucher, der bspw. als Signalisierungseinrichtung oder Sirene ausgebildet ist, über die Kommunikationsleitungen aktiviert und so in einen Betriebszustand höherer Stromaufnahme geschaltet werden. Daneben kann der mindestens eine Verbraucher auch selbstständig Betriebszustände unterschiedlicher Stromaufnahme einnehmen.

Ein Verfahren zur Überwachung von Zuleitungen zu mehreren parallel geschalteten niederohmigen Alarmgeräten sowie zur Überwachung der Alarmgeräte ist aus der Druckschrift DE 10 2005 060 123 A1 bekannt. Hierbei wird ein nichtlineares Schaltungselement, das in einer Richtung keinen Stromfluss zulässt, eingesetzt. Das nichtlineare Schaltungselement ist parallel zu den Alarmgeräten geschaltet und lässt in der anderen Stromflussrichtung für eine Spannung unterhalb eines bekannten Schwellwerts keinen Stromfluss zu und weist für eine Spannung in Höhe des Schwellwerts und darüber einen differentiellen Widerstand auf, der kleiner als jeder der Innenwiderstände der Alarmgeräte ist. Durch das Einprägen verschiedener Messströme und durch das Messen der dazugehörigen Spannungen lassen sich Werte für die Summe der Leitungswiderstände und der Innenwiderstände der Alarmgeräte bestimmen.

Ein Verfahren zur Überwachung einer auf Grenzwertmeldetechnik basierenden Meldelinie einer Brandmeldeanlage auf Störungen ist in der Druckschrift EP 1 855 261 A1 beschrieben. Dabei ist die Meldelinie im Betrieb mit einem Linienstrom beaufschlagt und weist ein durch eine TVS-Diode gebildetes Endglied auf. Bei einer Überwachung des Linienstroms und/oder der Linienspannung sowie für die Erkennung von Störungen erfolgt eine kurzzeitige Erhöhung des Linienstroms. Außerdem erfolgt für die Erkennung von weiteren Störungen zusätzlich eine kurzzeitige Absenkung des Linienstroms.

Eine Überwachungsvorrichtung zur Überwachung eines Betriebszustands von Versorgungs und/oder Signalleitungen eines Brandschutz- und/oder Gefahrenmeldesystems, ist in der Druckschrift DE 10 2008 003 799 A1 beschrieben. Diese Vorrichtung umfasst eine Messeinrichtung, die zur Erzeugung eines Messsignals in Abhängigkeit des Betriebszustands in den Versorgungs- und/oder Signalleitungen ausgebildet, verschaltet und/oder verschaltbar ist. Eine Auswerteeinrichtung ist dazu ausgebildet, das Messsignal auszuwerten und auf Basis der Auswertung ein Überwachungssignal auszugeben. Ferner ist eine steuerbare Signalquelle vorgesehen, die zur Einkopplung eines Prüfsignals in die Versorgungsund/oder Signalleitungen ausgebildet, verschaltet und/oder verschaltbar ist, wobei das Messsignal die Systemantwort der Versorgungs- und/oder Signalleitungenauf das Prüfsignal umfasst.

Die Druckschrift EP 2 093 737 A1 beschreibt ein aktives Linienabschlussmodul zur Überwachung einer Leitungsimpedanz von elektrischen Anlagen für den Einsatz am Ende von Brandmeldelinien. Hierbei sind zwischen den zu überwachenden Leitungen eine Konstantstromsenke mit Leuchtanzeige, ein Spannungsregler und ein intelligenter Elektronikbaustein so angeordnet, dass der intelligente Elektronikbaustein mittels einer Leitung mit der Konstantstromsenke verbunden ist.

In der Druckschrift WO 2009/087169 A1 werden eine Überwachungseinrichtung zur Überwachung des Betriebszustands von Versorungs- und/oder Signalleitungen eines Meldesystems, insbesondere eines Brandschutz- und/oder Gefahrenmeldesystems, und ein Verfahren zur Überwachung von Versorgungs- und/oder Signalleitungen eines Meldesystems beschrieben. Hierbei wird in einer Initialisie rungsphase durch Aufprägen eines ersten Prüfsignals eine Referenzsystemantwort gemessen und gespeichert. Während der Überwachung wird ein zweites Prüfsignal aufgeprägt und eine Betriebssystemantwort gemessen. Durch Vergleich von Betriebssystemantwort und Referenzsystemantwort wird der Zustand der Leitungen überwacht.

Bei dem beschriebenen Verfahren wird überprüft, ob die elektrischen Leitungen von der Energiequelle zu den Verbrauchern einen Widerstandswert aufweisen, der eine einwandfreie Funktion gewährleistet. Der elektrische Widerstand der Energieversorgungsleitung wird damit während des Betriebs gemessen. Überschreitet der gemessene Widerstandswert eine vorgegebene Schwelle, kann eine Störungsmeldung veranlasst werden.

Es ist zu beachten, dass ein zu hoher Widerstandswert im Ruhebetrieb das System nicht nachteilig beeinflusst, jedoch kann der im aktivierten Fall höhere Strombedarf aufgrund eines zu großen Leitungswiderstands nicht mehr gewährleistet werden.

Nachteilig bei der bekannten Vorgehensweise ist insbesondere, dass der Einfluss der Verbraucher nicht berücksichtigt wird.

Offenbarung der Erfindung

Vor diesem Hintergrund werden ein Verfahren zum Überwachen von Energieversorgungsleitungen mit den Merkmalen des Anspruchs 1 und eine Überwachungseinrichtung nach Anspruch 7 zur Durchführung des Verfahrens vorgestellt.

Das erfindungsgemäße Verfahren kompensiert die genannten Einflüsse von Verbrauchern, insbesondere von Verbrauchern mit R- und P-Charakteristik. Damit ist eine Bestimmung des Leitungswiderstands R während des Betriebs der Verbraucher ohne Verfälschung möglich.

Mit dem vorgestellten Verfahren ist es möglich, in Brandmeldesysteme eine sich langsam ausbildende Unterbrechung oder Widerstandserhöhung eines Übertragungswegs, auch einer Energieversorgungsleitung, zu erkennen, bevor eine unerwünschte Beeinträchtigung des Systems auftritt.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Kurze Beschreibung der Zeichnungen

Figur 1     zeigt eine Ausführungsform der beschriebenen Überwachungseinrichtung.

Figur 2     zeigt in einem Flussdiagramm eine Ausführung des vorgestellten Verfahrens.

Ausführungsformen der Erfindung

Die Erfindung ist anhand von Ausführungsformen in den Zeichnungen schematisch dargestellt und wird unter Bezugnahme auf die Zeichnungen ausführlich beschrieben.

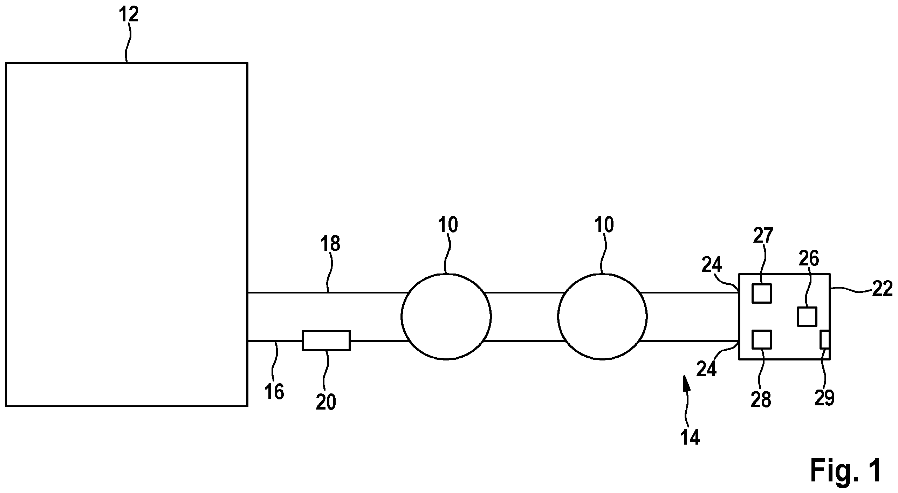

In Figur 1 ist schematisch eine Systemkonfiguration dargestellt. Verbraucher 10 sind mit einer Zentrale 12 über Leitungen 14 verbunden. Dabei werden die Verbraucher 10 über Energieversorgungsleitungen 16 mit Spannung versorgt. Eine Aktivierung der Verbaucher 10 erfolgt über separate Kommunikationsleitungen 18. Der Leitungswiderstand der Energieversorgungsleitungen 16 ist mit Bezugsziffer 20 bezeichnet als R dargestellt. Am Ende der Leitungen 14 ist eine Überwachungseinrichtung 22 zur Überwachung der Leitungen 14 vorgesehen.

Die Überwachungseinrichtung 22 ist in der Regel über Anschlüsse 24 schaltungstechnisch mit den Verbrauchern 10 über die Leitungen 14 verbunden. Aufgabe der Überwachungseinrichtung 22 ist es, den Leitungswiderstand R 20 zu überwachen und ggf. die Zentrale 12 über einen Leitungswiderstand 20, der auf einen Kurzschluss oder eine Unterbrechung hinweist, schon bei der Entstehung zu informieren.

Die Überwachungseinrichtung 22 verfügt über einen Microcontroller 26, der die Überwachungseinrichtung 22 steuert. Weiterhin ist eine Signalquelle 27 und eine Auswerteeinheit 28 vorgesehen. Mit der Signalquelle 27, die bspw. als steuerbare Konstantstromquelle ausgebildet ist, werden die Prüfsignale erzeugt, die aufgeprägt werden und die Messignale als Antwort auf die Prüfsignale bewirken. Mit der Auswerteeinheit 28 werden ermittelte Messwerte mit Referenzwerten verglichen. Die Auswerteeinheit 28 kann als separates Bauteil oder auch in dem Microcontroller 27 integriert als Software oder Hardware implementiert sein. Weiterhin ist bei der Überwachungseinrichtung 22 eine Schnittstelle 29 zur manuellen Eingabe von Verbraucherparametern vorgesehen, die bei der Ermittlung des Leitungswiderstands R 20 berücksichtigt und kompensiert werden. Alternativ können diese Verbraucherparameter auch über die Kommunikationsleitung 18 zu der Überwachungseinrichtung 22 übertragen werden. In noch einer weiteren Ausführung verfügt die Überwachungseinrichtung 22 über eine Einrichtung, um die Verbraucherparameter selbst erfassen zu können.

Zur Ermittlung des Leitungswiderstands R 20 durch die Überwachungseinrichtung 22 wird in einem ersten Schritt die Spannung U0 am Ende der Energieversorgungsleitungen 16 gemessen und gespeichert. Anschließend wird bspw. mittels einer einstellbaren Stromsenke die Energieversorgungsleitungen 16 so hoch belastet, bis aufgrund des Leitungswiderstands 20 ein signifikanter Spannungseinbruch festzustellen ist. Aus der im belasteten Fall gemessenen Spannung U1 und dem entsprechenden Laststrom I_Last berechnet sich der Leitungswiderstand R_calc wie folgt:

$$R\_calc = \frac{U0 - U1}{I\_Last}$$

Die Belastung der Energieversorgungsleitungen 16 und die Berechnung des Leitungswiderstands 20 erfolgt in periodischen Abständen. Nach Ermittlung des Leitungswiderstands R_calc wird dieser mit einem vorgegebenen Maximalwert Rmax verglichen. Wird die Schwelle Rmax überschritten, kann über die Kommikationsleitungen 18 eine Störungsmeldung zu der Zentrale 12 übermittelt und angezeigt werden.

Die vorstehende Gleichung gilt jedoch für den Leitungswiderstand nur für Verbraucher, die eine Konstantstromsenke, d.h. I = const über den gesamten Betriebsspannungsbereich, darstellen.

Für den Fall, dass Verbraucher vorgesehen sind, die ihren Betriebsstrom nach $I = U/R_V$, d.h. der Verbraucher stellt eine konstante ohmsche Last mit $R_V$ = const dar, oder $I = P_V/U$, d.h. der Verbraucher stellt eine Leistungssenke mit $P_V$ = const dar, einstellen, wird die Differenz U0 - U1 nicht mehr ausschließlich durch I_Last bestimmt, sondern auch durch die angeschlossenen Verbraucher mit R- bzw. P-Charakteristik.

Bei einem P-Verbraucher wird aufgrund des Prüfstroms I_Last und des Spannungsabfalls am Leitungswiderstand R die Betriebsspannung der Verbraucher erniedrigt. Eine Verringerung der Betriebsspannung führt bei einem P-Verbraucher nach $I = P_V/U$ zu einem Anstieg des Betriebsstroms, was wiederum aufgrund des Leitungswiderstands R zu einer weiteren Erhöhung der Differenz U0 - U1 führt. Die gemessene Differenz ist daher größer als die eigentlich durch I_Last hervorgerufene Differenz. Somit wird der dabei ermittelte Widerstandswert R_calc zu groß.

Bei einem R-Verbraucher führt die Verringerung der Betriebsspannung aufgrund I_Last und des Leitungswiderstands nach $I = U/R_V$ zu einer Verringerung der Differenz U0 - U1 gegenüber der nur durch I_Last hervorgerufenen Differenz und damit zu einem ermittelten Widerstandswert R_calc, der zu klein ist.

Das erfindungsgemäße Verfahren kompensiert die genannten Einflüsse von Verbrauchern, insbesondere von Verbrauchern mit R- und P-Charakteristik, so dass eine Bestimmung des Leitungswiderstands R während des Betriebs der Verbraucher ohne Verfälschung möglich ist.

Zur Kompensation werden die Verbraucherparameter Leistung $P_V$ und Widerstand $R_V$ benötigt. Diese Werte können durch einmalige Messungen manuell ermittelt werden, bspw. durch Aufnahme der I(U)-Kennlinie. Die gefundenen Parameter werden der Überwachungseinrichtung 22 mittels der Kommunikationsleitungen 18 übermittelt oder manuell eingegeben. Bei mehreren angeschlossenen Verbrauchern werden die summierte Gesamtleistung und der Gesamtwiederstnd (Parallelschaltung) übergeben.

Die Überwachungseinrichtung 22 kann dann mit einer angepassten Bestimmungsgelichung den korrekten Wert des Leitungswiderstands ermitteln:

$$R\_calc = \frac{U0-U1}{I\_Last + \Delta I\_P - \Delta I\_R} = \frac{U0-U1}{I\_Last + \frac{P_V}{U1} - \frac{P_V}{U0} - \frac{U0-U1}{R_V}}$$

Hierbei wird der durch die Überwachungseinrichtung 22 hervorgerufene Prüfstrom I_Last durch die Stromerhöhung der P-Verbraucher und die Stromerniedrigung der R-Verbraucher korrigiert. Damit steht in der Bestimmungsgleichung der effektiv durch den Widerstand R 20 fließende Laststrom, der aufgrund von I_Last generiert wird.

Bei Verbrauchern, die Mischformen der genannten Charakteristika (I = cons, P = const, R = const) ausbilden, können die verschiedenen Parameter durch Messung separat bestimmt werden.

Nach geltenden Vorschriften wird für Brandmeldesysteme gefordert, dass sich eine langsam ausbildende Unterbrechung - Widerstanserhöhung - eines Übertragungswegs erkannt werden muss, bevor eine unerwünschte Beeinträchtigung des Systems auftritt. Dies ist mit dem vorgestellten Verfahren möglich.

Die vorstehend erläuterten Effekte können zu signifikanten Verfälschungen der Widerstandsbestimmung führen, wenn bislang bekannte Verfahren eingesetzt werden. Dies kann zu einer falschen Störungsmeldung oder zu einer verspäteten Anzeige einer tatsächlichen Störung führen.

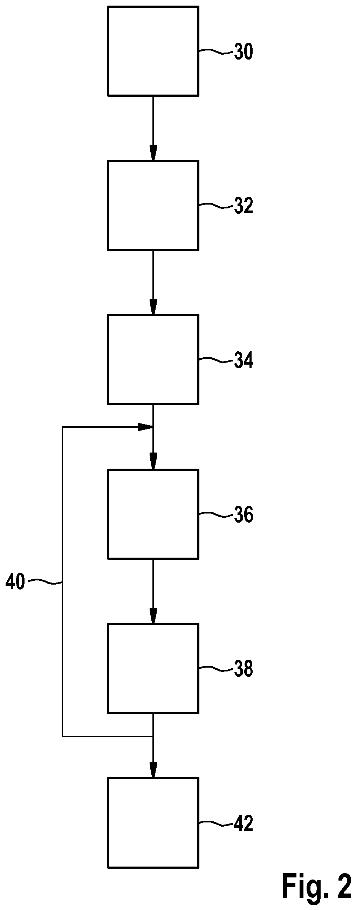

In Figur 2 ist ein Ablauf eines Ausführung des erläuterten Verfahrens dargestellt. In einem ersten Schritt 30 wird durch einmalige Messung die Verbraucherparameter Leistung $P_V$ und Widerstand $R_V$ ermittelt. Dies kann bspw. manuell durch Aufnahme der I(U)-Kennlinie erfolgen.

In einem zweiten Schritt 32 werden die ermittelten Verbraucherparameter an die Überwachungseinrichtung übermittelt. Dies kann bspw. durch manuelle Eingabe oder durch Übermittlung über Kommunikationsleitungen erfolgen. Mit diesen Verbraucherparametern kann die Überwachungseinrichtung den korrekten Wert des Leitungswiderstands ermitteln.

In einem dritten Schritt 34 wird in einer Initialisierungsphase durch Aufprägen eines Initialisierungsprüfsignals auf die Leitungen, bspw. auf Versorgungs- und Signalleitungen, eine Referenzsystemantwort gemessen und gespeichert.

Während der Überwachung wird in einem vierten Schritt 36 ein Prüfsignal aufgeprägt, wobei als Messignal eine Betriebssystemantwort gemessen wird. Dabei werden die eingangs ermittelten Verbraucherparameter berücksichtigt, um den korrekten Wert des Leitungswiderstands zu ermitteln. Die Betriebssystemantwort wird in einem fünften Schritt 38 mit der Referenzsystemantwort verglichen. Während des Betriebs werden der vierte Schritt 36 und der fünfte Schritt 38 periodisch wiederholt (Pfeil 40).

Wird ein Leitungswiderstand festgestellt, der auf einen Fehler hinweist, so wird in einem sechsten Schritt 42 ein Warnsignal an die Zentrale übermittelt.

In einer alternativen Ausführung wird nicht in einer Initialisierungsphase durch Aufprägen eines Initialisierungsprüfsignals auf die Leitungen eine Referenzsystemantwort gemessen und gespeichert, die dann in einem anschließenden Schritt mit der Betriebssystemantwort verglichen wird, die durch Aufprägen eines Prüfsignals gewonnen wird. Bei dieser Ausführung wird lediglich durch Aufprägen eines Prüfsignals der Leitungswiderstand direkt gemessen und quantifiziert. Ein Vergleich mit einer in einer Initialisierungsphase gewonnenen Referenzsystemantwort ist nicht erforderlich.

**Patentansprüche**

1. Verfahren zum Überwachen von Energieversorgungsleitungen (16) in einem System, in dem mindestens ein elektrischer Verbraucher (10) über die Energieversorgungsleitungen (16) an eine Zentrale (12) angeschlossen ist, bei dem mit einer Überwachungseinrichtung (22) ein Prüfsignal auf die Energieversorgungsleitungen (16) gegeben wird, um den elektrischen Widerstand (20) der Energieversorgungsleitungen (16) zu bestimmen, wobei zur Ermittlung des Widerstands (20) der Energieversorgungsleitungen (16) durch die Überwachungseinrichtung (22) eine Spannung U0 am Ende der Energieversorgungsleitungen (16) gemessen und gespeichert wird, wobei die Energieversorgungsleitungen (16) anschließend so hoch belastet werden, bis aufgrund des Widerstands (20) ein signifikanter Spannungseinbruch festgestellt wird, wobei im belasteten Fall eine Spannung U1 und ein entsprechender Laststrom I_Last gemessen werden, **dadurch gekennzeichnet, dass** der Widerstand (20) R_calc = (U0 - U1)/(I_Last) berechnet wird, wobei Einflüsse des mindestens einen Verbrauchers (10) bei der Ermittlung des Widerstands (20) durch Verbraucherparameter berücksichtigt und kompensiert werden.

2. Verfahren nach Anspruch 1, bei dem die Einflüsse des mindestens einen Verbrauchers (10) anhand von Verbraucherparametern definiert werden.

3. Verfahren nach Anspruch 1 oder 2, bei dem die Parameter durch einmaliges Messen einer I(U)-Kennlinie ermittelt werden.

4. Verfahren nach einem der Ansprüche 1 bis 3, bei dem Einflüsse mindestens einen Verbrauchers (10) mit R-Charakteristik, der eine konstante ohmsche Last darstellt, kompensiert werden.

5. Verfahren nach einem der Ansprüche 1 bis 4, bei dem Einflüsse mindestens einen Verbrauchers (10) mit P-Charakteristik, der eine Leistungssenke mit konstanter Leistung Pv darstellt, kompensiert werden.

6. Verfahren nach einem der Ansprüche 1 bis 5, bei dem in einer Initialisierungsphase durch Aufprägen eines Initialisierungsprüfsignals auf die Energieversorgungsleitungen (16) eine Referenzsystemantwort der Energieversorgungsleitungen (16) gemessen wird und während der Überwachung das Prüfsignal aufgeprägt wird, wobei eine Betriebsantwort gemessen wird, und wobei durch Vergleich von Referenzantwort und Betriebssystemantwort der Zustand der Energieversorgungsleitungen (16) überwacht wird.

7. Überwachungseinrichtung, die über eine Signalquelle (27) und eine Auswerteeinheit (28) verfügt, zum Überwachen des Betriebszustands von Energieversorgungsleitungen (16) in einem System, in dem mindestens ein elektrischer Verbraucher (10) über die Energieversorgungsleitungen (16) an eine Zentrale (12) angeschlossen ist, wobei die Signalquelle (27) zur Einkopplung eines Prüfsignals in die Energieversorgungsleitungen (16) ausgebildet ist, wobei auf das Prüfsignal in Abhängigkeit des Betriebszustands der Energieversorgungsleitungen (16) beim Überwachen als Antwort ein Messsignal bewirkt wird, und wobei die Auswerteeinheit (28) dazu ausgebildet ist, das Messsignal auszuwerten, wobei die Auswerteeinheit (28) dazu ausgebildet ist, das Messsignal unter Berücksichtigung von Verbraucherparametern auszuwerten, wobei zur Ermittlung des Widerstands (20) der Energieversorgungsleitungen (16) durch die Überwachungseinrichtung (22) eine Spannung U0 am Ende der Energieversorgungsleitungen (16) zu messen und zu speichern ist, wobei die Energieversorgungsleitungen (16) anschließend mittels einer einstellbaren Stromsenke so hoch zu belasten sind, bis aufgrund des Widerstands (20) ein signifikanter Spannungseinbruch festzustellen ist, wobei im belasteten Fall eine Spannung U1 und ein entsprechender Laststrom I_Last zu messen sind, **dadurch gekennzeichnet, dass** die Auswerteeinheit (28) dazu ausgebildet ist, den Widerstand (20) R_calc = (U0 - U1)/(I_Last) zu berechnen, und Einflüsse des mindestens einen Verbrauchers (10) bei der Ermittlung des Widerstands (20) durch die Verbraucherparameter zu berücksichtigen und zu kompensieren.

8. Überwachungseinrichtung nach Anspruch 7, die dazu ausgebildet ist, Verbraucherparameter mittels Kommunikationsleitungen (18) zu empfangen.

9. Überwachungseinrichtung nach Anspruch 7 oder 8, die mit einer Schnittstelle (29) für eine manuelle Eingabe der Verbraucherparameter ausgebildet ist.

10. Überwachungseinrichtung nach einem der Ansprüche 7 bis 9, bei der die Signalquelle (27) als steuerbare Konstantstromquelle ausgebildet ist.

**Claims**

1. Method for monitoring energy supply lines (16) in a system, in which at least one electrical load (10) is connected to a control centre (12) by means of the energy supply lines (16), in which method a test signal is passed to the energy supply lines (16) using a monitoring device (22) in order to determine the electrical resistance (20) of the energy supply lines (16), wherein a voltage U0 at the end of the energy supply lines (16) is measured and stored by the monitoring device (22) for the purpose of ascertaining the resistance (20) of the energy supply lines (16), wherein the energy supply lines (16) are then subjected to high loading until a significant voltage dip is identified on account of the resistance (20), wherein, in the loaded case, a voltage U1 and a corresponding load current I_Load are measured, **characterized in that** the resistance (20) R_calc = (U0 - U1)/(I_Load) is calculated, wherein influences of the at least one load (10) are taken into account in the ascertainment of the resistance (20) and compensated by load parameters.

2. Method according to Claim 1, in which the influences of the at least one load (10) are defined based on load parameters.

3. Method according to Claim 1 or 2, in which the parameters are ascertained by onetime measurement of an I(U) characteristic curve.

4. Method according to one of Claims 1 to 3, in which influences of at least one load (10) having an R characteristic are compensated, which load constitutes a constant ohmic load.

5. Method according to one of Claims 1 to 4, in which influences of at least one load (10) having a P characteristic are compensated, which load constitutes a power sink having a constant power Pv.

6. Method according to one of Claims 1 to 5, in which a reference system response of the energy supply lines (16) is measured in an initialization phase by impression of an initialization test signal onto the energy supply lines (16) and the test signal is impressed during the monitoring process, wherein an operating response is measured, and wherein the state of the energy supply lines (16) is monitored by comparing the reference response and the operating system response.

7. Monitoring device, which has a signal source (27) and an evaluation unit (28), for monitoring the operating state of energy supply lines (16) in a system, in which at least one electrical load (10) is connected to a control centre (12) by means of the energy supply lines (16), wherein the signal source (27) is designed to couple a test signal into the energy supply lines (16), wherein a measurement signal is induced as a response onto the test signal depending on the operating state of the energy supply lines (16) during monitoring, and wherein the evaluation unit (28) is designed to evaluate the measurement signal, wherein the evaluation unit (28) is designed to evaluate the measurement signal taking load parameters into account, wherein a voltage U0 at the end of the energy supply lines (16) can be measured and can be stored for the purpose of ascertaining the resistance (20) of the energy supply lines (16) by the monitoring device (22), wherein the energy supply lines (16) can then be subjected to high loading by means of a settable current sink until a significant voltage dip can be identified on account of the resistance (20), wherein, in the loaded case, a voltage U1 and a corresponding load current I_Load can be measured, **characterized in that** the evaluation unit (28) is designed to calculate the resistance (20) R_calc = (U0 - U1)/(I_Load) and to take into account influences of the at least one load (10) in the ascertainment of the resistance (20) and to compensate the influences by the load parameters.

8. Monitoring device according to Claim 7, which is designed to receive load parameters by means of communication lines (18).

9. Monitoring device according to Claim 7 or 8, which is designed with an interface (29) for manual input of the load parameters.

10. Monitoring device according to one of Claims 7 to 9, in which the signal source (27) is designed as a controllable constant current source.

**Revendications**

1. Procédé pour surveiller des lignes d'alimentation en énergie (16) dans un système, dans lequel au moins un consommateur électrique (10) est raccordé à une centrale (12) par les lignes d'alimentation en énergie (16), dans lequel on émet un signal de contrôle sur les lignes d'alimentation en énergie (16) au moyen d'un dispositif de surveillance (22), afin de déterminer la résistance électrique (20) des lignes d'alimentation en énergie (16), dans lequel, pour la détermination de la résistance (20) des lignes d'alimentation en énergie (16) par le dispositif de surveillance (22), on mesure et on mémorise une tension U0 à l'extrémité des lignes d'alimentation en énergie (16), dans lequel on charge ensuite les lignes d'alimentation en énergie (16) à un niveau tel qu'en raison de la résistance (20) on constate une importante chute de tension, dans lequel on mesure dans le cas de charge une tension U1 et un courant de charge correspondant I_charge,
**caractérisé en ce que**
l'on calcule la résistance (20) R_calc = (U0 - Ul)/(I_charge), des influences dudit au moins un consommateur (10) étant prises en compte par des paramètres du consommateur lors de la détermination de la résistance (20) et étant compensées.

2. Procédé selon la revendication 1, dans lequel on définit les influences dudit au moins un consommateur (10) à l'aide de paramètres du consommateur.

3. Procédé selon la revendication 1 ou 2, dans lequel on détermine les paramètres par une mesure unique d'une caractéristique I(U).

4. Procédé selon l'une quelconque des revendications 1 à 3, dans lequel on compense des influences d'au moins un consommateur (10) avec une caractéristique R, qui représente une charge ohmique constante.

5. Procédé selon l'une quelconque des revendications 1 à 4, dans lequel on compense des influences d'au moins un consommateur (10) avec une caractéristique P, qui représente un récepteur d'énergie à puissance constante $P_V$.

6. Procédé selon l'une quelconque des revendications 1 à 5, dans lequel, dans une phase d'initialisation, on mesure par application d'un signal de contrôle d'initialisation sur les lignes d'alimentation en énergie (16) une réponse de système de référence des lignes d'alimentation en énergie (16) et on applique le signal de contrôle pendant la surveillance, dans lequel on mesure une réponse de fonctionnement, et dans lequel on surveille l'état des lignes d'alimentation en énergie (16) par une comparaison de la réponse de référence et de la réponse du système en fonctionnement.

7. Dispositif de surveillance, qui est doté d'une source de signaux (27) et d'une unité d'évaluation (28), pour la surveillance de l'état de fonctionnement de lignes d'alimentation en énergie (16) dans un système, dans lequel au moins un consommateur électrique (10) est raccordé à une centrale (12) par les lignes d'alimentation en énergie (16), dans lequel la source de signaux (27) est conçue pour le couplage d'un signal de contrôle dans les lignes d'alimentation en énergie (16), dans lequel on provoque lors de la surveillance à titre de réponse un signal de mesure sur le signal de contrôle en fonction de l'état de fonctionnement des lignes d'alimentation en énergie (16), et dans lequel l'unité d'évaluation (28) est conçue pour évaluer le signal de mesure, dans lequel l'unité d'évaluation (28) est apte à évaluer le signal de mesure en tenant compte de paramètres du consommateur, dans lequel, pour la détermination de la résistance (20) des lignes d'alimentation en énergie (16) par le dispositif de surveillance (22), on doit mesurer et mémoriser une tension U0 à l'extrémité des lignes d'alimentation en énergie (16), dans lequel on doit charger ensuite les lignes d'alimentation en énergie (16) au moyen d'un récepteur de courant réglable, à un niveau tel qu'en raison de la résistance (20) on doive constater une importante chute de tension, dans lequel on doit mesurer dans le cas de charge une tension U1 et un courant de charge correspondant I_charge,

**caractérisé en ce que** l'unité d'évaluation (18) est conçue pour calculer la résistance (20) R_calc = (U0 - UI)/(I_charge), et pour tenir compte, par les paramètres du consommateur, des influences dudit au moins un consommateur (10) lors de la détermination de la résistance (20)et pour les compenser.

8. Dispositif de surveillance selon la revendication 7, qui est conçu pour recevoir des paramètres de consommateur au moyen de lignes de communication (18).

9. Dispositif de surveillance selon la revendication 7 ou 8, qui est réalisé avec une interface (29) pour une entrée manuelle des paramètres de consommateur.

10. Dispositif de surveillance selon l'une quelconque des revendications 7 à 9, dans lequel la source de signaux (27) est réalisée sous la forme d'une source de courant constant commandable.

Fig. 1

**Fig. 2**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005060123 A1
- EP 1855261 A1
- DE 102008003799 A1
- EP 2093737 A1
- WO 2009087169 A1